# EUROPEAN PATENT APPLICATION

(11) **EP 4 312 472 A1**
(43) Date of publication of application: **31.01.2024**
(21) Application number: 23181992.1
(22) Date of filing: 28.06.2023
(51) Int. Cl.: H05K 3/32, H05K 3/34, H05K 3/36

(54) **BATTERY MODULE INCLUDING CONDUCTIVE BONDING PORTION FOR BONDING PCB AND FPCB, AND METHOD OF BONDING PCB**

(30) Priority: 26.07.2022 KR 20220092457
(71) Applicant: SK On Co., Ltd., Seoul 03161 (KR)
(72) Inventor: KIM, Eun Young, 34124 Daejeon (KR); KANG, Ji Eun, 34124 Daejeon (KR); LEE, Tae Gu, 34124 Daejeon (KR); JUNG, Hyun Jay, 34124 Daejeon (KR); JO, Soo Hwan, 34124 Daejeon (KR)
(74) Representative: Prüfer & Partner mbB Patentanwälte · Rechtsanwälte

(57) **Abstract**

A battery module includes a printed circuit board (PCB) having a copper pattern; a flexible printed circuit board (FPCB) having a copper pattern; and a conductive bonding portion for bonding the PCB to the FPCB, wherein the copper pattern of the PCB and the copper pattern of the FPCB are electrically connected to each other by conductive metal particles, and wherein at least one of the copper pattern of the PCB and the copper pattern of the FPCB has at least one or more alloy layers selected from a group consisting one or more of Ni-Sn and Au-Ni-Sn-Bi.

## Description

### BACKGROUND

### 1. FIELD

The present disclosure relates to an electric vehicle battery module in which a printed circuit board (PCB) and a flexible printed circuit board (FPCB) are bonded to each other, and a method of bonding a PCB.

### 2. DESCRIPTION OF RELATED ART

An anisotropic conductive film (ACF) may generally refer to a film-shaped adhesive in which conductive metal particles are dispersed in resin such as epoxy, and may refer to a polymer film with electrical anisotropy and adhesion, which may have electrical conductivity in a film thickness direction and may have electrical insulation in a plane direction.

An anisotropic conductive film may be used to connect two circuits, and a commercially available anisotropic conductive film often include electrically conductive metal particles and a thermosetting adhesive resin. In the case of connecting circuits using an anisotropic conductive film, the anisotropic conductive film may be disposed between circuits to be connected, a heating and pressurizing process of applying a predetermined pressure while applying heat or ultrasonic waves under predetermined conditions may be performed to cure the resin. Accordingly, circuit terminals may be electrically connected by the electrically conductive metal particles. A thermosetting insulating adhesive resin may be filled in a region between electrodes adjacent to each other, and the electrically conductive metal particles may be present independently of each other in the resin and may provide electrical insulation between the electrodes.

### SUMMARY

An aspect of the present disclosure is to provide a technique of bonding an anisotropic conductive film for bonding an electric vehicle battery module, more particularly, PCB to FPCB of an electric vehicle battery module.

According to an aspect of the present disclosure, a battery module includes a printed circuit board (PCB) having a copper pattern; a flexible printed circuit board (FPCB) having a copper pattern; and a conductive bonding portion for bonding the PCB to the FPCB, wherein the copper pattern of the PCB and the copper pattern of the FPCB are electrically connected to each other by a conductive metal particles, and wherein at least one of the copper pattern of the PCB and the copper pattern of the FPCB has at least one or more alloy layers selected from a group consisting one or more of Ni-Sn and Au-Ni-Sn-Bi.

The conductive metal particles may be at least one or more selected from a group consisting of nickel, a Sn-Bi alloy and a Sn-Au-Cu alloy.

The conductive bonding portion may include a thermosetting resin.

The conductive bonding portion may further include silica.

The silica may be included in a range from more than 0 parts by weight to 30 parts by weight or less based on 100 parts by weight of a thermosetting resin.

The conductive bonding portion may have a degree of curing of 70 to 97%.

According to another aspect of the present disclosure, a method of bonding a PCB includes providing a laminate by interposing an anisotropic conductive film including a thermosetting resin and a conductive metal particles between a printed circuit board (PCB) having a copper pattern and a flexible printed circuit board (FPCB) having a copper pattern; and bonding the PCB to the FPCB by heating and pressurizing the laminate, wherein at least one of the copper pattern of the PCB and the copper pattern of the FPCB has at least one plating layer selected from a group consisting one or more of a Ni plating layer and an Au-Ni plating layer.

The conductive metal particles may be at least one or more selected from a group consisting of nickel, a Sn-Bi alloy and a Sn-Au-Cu alloy.

The bonding of the PCB to the FPCB may be performed by thermal fusion.

The bonding of the PCB to the FPCB may be performed by ultrasonic welding.

According to the other aspect of the present disclosure, a battery module includes a printed circuit board (PCB) having a copper pattern; a flexible printed circuit board (FPCB) having a copper pattern; and a conductive bonding portion for bonding the PCB to the FPCB, wherein the conductive bonding portion includes conductive metal particles, a thermosetting resin, and a solder, and wherein the solder has a higher melting temperature than the thermosetting resin, and the conductive metal particles have a higher melting temperature than the thermosetting resin.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a diagram illustrating a bonding mechanism of when bonding a PCB and a FPCB using an anisotropic conductive film according to one embodiment of the present disclosure;
FIG. 2 is an SEM image of a cross-sectional surface of a bonding portion according to another embodiment of the present disclosure;
FIG. 3 is an image of a cross-sectional surface of a bonding portion formed by ACF bonding according to still another embodiment of the present disclosure, illustrating that a Ni-Sn alloy layer is formed on a copper pattern of a PCB; and
FIG. 4 is an image of a cross-sectional surface of a bonding portion formed by ACF bonding according to yet another embodiment of the present disclosure, illustrating that an Au-Ni-Sn-Bi alloy layer is formed on a copper pattern of a PCB.

### DETAILED DESCRIPTION

The present invention recognized that, when the thermosetting resin is not sufficiently melted and does not have fluidity during heating, a resin layer may be formed between the electrode and the solder particles. Accordingly, it may be difficult to accumulate solder particles on or between electrodes, and the solder particles may not melt and may be present in a particulate state, such that a contact area between circuit terminals may be significantly small, and it may be difficult to secure electrical connection reliability between circuit terminals.

Also, the existing anisotropic conductive film technology does not require rigidity of a bonding portion and may be mainly applied to technical fields such as mobile phone, home appliances, and vehicle displays which may be less affected by temperature and humidity. However, the technique of bonding a PCB and a FPCB using an anisotropic conductive film as described above has not been applied to electric vehicle battery modules exposed to harsh environments, such as harsh temperature and humidity conditions and physical impacts applied during module assembly, which may deform the bonding portion.

Specifically, the present invention recognized that, when bonding a PCB and a FPCB, dynamic temperature and humidity conditions may vary greatly depending on a driving environment of a vehicle, vibrations applied to a battery module due to the driving environment may increase, and mechanical stress may be severely applied when assembling modules, such that, due to the harsh environment, it has been difficult to maintain electrical bonding.

Accordingly, a technique of securing reliability of electrical bonding of the PCB to the FPCB by reducing deformation of the bonding portion for bonding PCB-FPCB in an electric vehicle battery module is provided below.

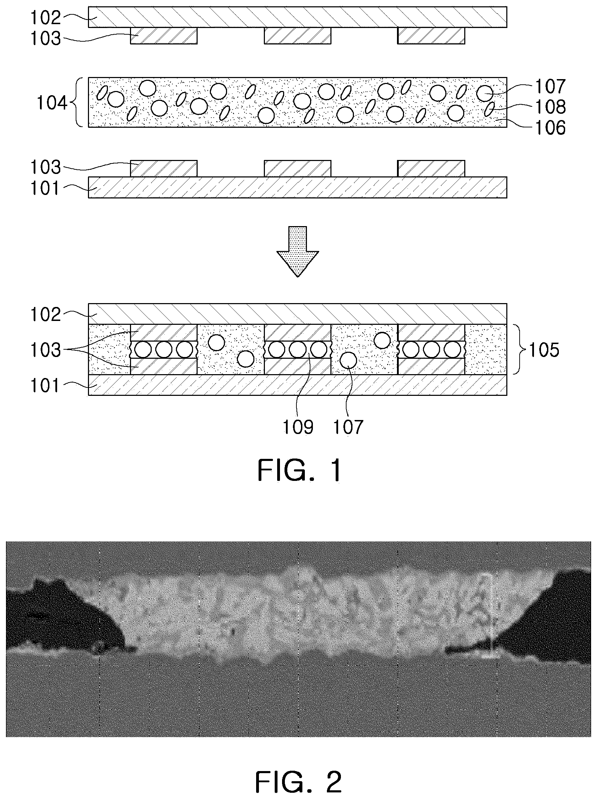

FIG. 1 is a diagram illustrating a bonding mechanism of when bonding a PCB 101 and a FPCB 102 using an anisotropic conductive film 104, herein after referred to as "ACF," according to one embodiment.

FIG. 2 is an SEM image of a cross-sectional surface of a bonding portion according to one embodiment.

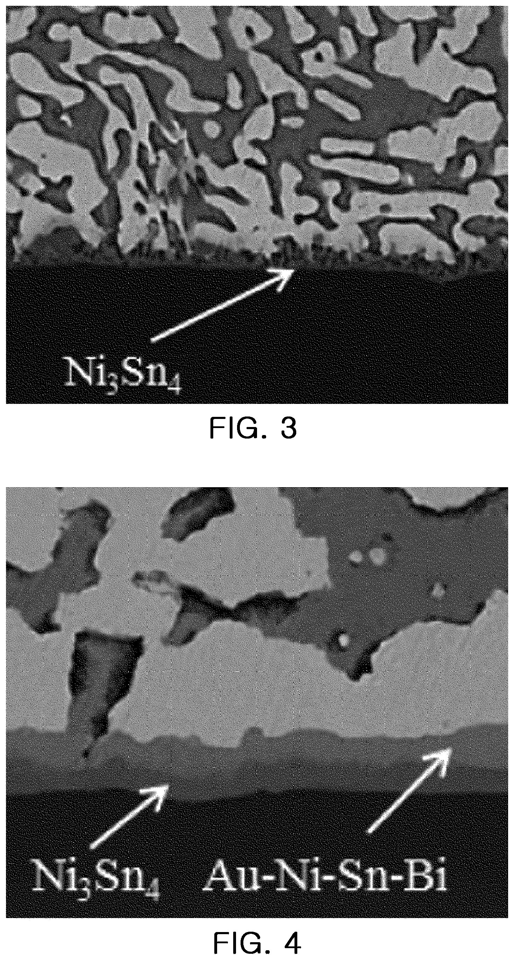

FIG. 3 is an image of a cross-sectional surface of a bonding portion formed by ACF bonding according to another embodiment, illustrating that a Ni-Sn alloy layer is formed on a copper pattern (e.g., pattern 103 shown in FIG. 1) of a PCB.

FIG. 4 is an image of a cross-sectional surface of a bonding portion formed by ACF bonding according to still another embodiment, illustrating that an Au-Ni-Sn-Bi alloy layer is formed on a copper pattern of a PCB.

The present disclosure relates to a battery module in which a PCB 101 and a FPCB 102 are bonded using an ACF 104, and by improving the bonding strength of the PCB 101 to the FPCB 102, the reliability of electrical bonding may be improved.

According to a further embodiment, a battery module may include a PCB 101 having a copper pattern 103; a FPCB 102 having a copper pattern 103; and a conductive bonding portion 105 for bonding the PCB 101 to the FPCB 102, the copper pattern 103 of the PCB 101 and the copper pattern 103 of the FPCB 102 are electrically connected by a conductive metal particles 107, and at least one of the copper pattern 103 of the PCB 101 and the copper pattern 103 of the FPCB 102 has at least one or more alloy layers selected from a group consisting of one or more of Ni-Sn and Au-Ni-Sn-Bi. The present disclosure is not limited to the specific metals described herein, as other metals with similar electrical, mechanical, and melting properties can be used to form the battery module of FIG. 1.

The PCB 101 and the FPCB 102 may include a copper pattern 103 on one surface of each substrate constituting a circuit board, and the PCB 101 and the FPCB 102 may have the same pattern, and may have an overlapping structure when the patterned surfaces of the PCB 101 and the FPCB 102 opposes each other. That is, the two conductive or metal patterns on the PCB and FPCB may be mirror images.

In one embodiment, the copper patterns 103 of the PCB 101 and the FPCB 102 may be electrically connected to each other, and the copper patterns 103 may be electrically connected using ACF 104.

ACF 104 may be an adhesive film in which conductive metal particles 107 are dispersed in a thermosetting resin 106. ACF 104is disposed between two components, that is, between the PCB 101 and the FPCB 102, and the components may be bonded to each other by the adhesive force of the thermosetting resin 106. In this case, by allowing the two components to be in contact with each other by the conductive metal particles 107, the components may be electrically connected to each other.

ACF 104 may allow a current to flow only in the thickness direction by electrical connection between the two components by the conductive metal particles, and may provide insulation in other directions.

ACF 104 may include a thermosetting resin 106 and a conductive metal particles 107. The conductive metal particles 107 may be at least one or more selected from a group consisting of nickel, a Sn-Bi alloy, and a Sn-Au-Cu alloy.

The thermosetting resin 106 may work as a binder for fixing the conductive metal particles 107, may provide adhesive strength between the PCB 101 and the FPCB 102 (to be bonded to each other by the ACF 104), may further provide insulation between electrodes (that is between the copper patterns 103) adjacent to each other, and may be provided as a matrix of conductive bonding portion for bonding the PCB 101 and the FPCB 102 together.

The thermosetting resin 106 (which is possible to be melted by heat) may be suitably used in one embodiment.

For the thermosetting resin 106, a resin commonly used in anisotropic conductive film may be used, for example, but not limited to, polyimide resin, polyamide resin, epoxy resin, phenoxy resin, polymethacrylate resin, polyacrylate resin, polyurethane resin, polyester resin, polyesterurethane resin, poly vinyl butyral resin, styrene-butyrene-styrene (SBS) resin and modified epoxy resin thereof, styrene-ethylene-butylene-styrene (SEES) resin and modified resin thereof, or acrylonitrile butadiene rubber (NBR) and hydrogenated products thereof, which may be used alone or in combination of two or more thereof. More specifically, a polyurethane resin, a polyacrylate resin, or an epoxy resin may be used.

The thermosetting resin 106 may have a melting temperature lower than the melting temperature of a solder 108 included in the anisotropic conductive film. When the melting temperature of the thermosetting resin 106 is higher than the melting temperature of the solder 108, and ACF 104 is bonded by applying heat, the thermosetting resin 106 may not melt even when the solder 108 is melted, such that resin 106 may not flow outwardly from the copper pattern 103, and thermosetting resin 106 may remain between the solder 108 and the copper pattern 103, which would hinder the electrical connection. In this case, the thermosetting resin 106 may have a melting temperature ranging from 40°C to 80°C.

ACF 104 may include nickel as the conductive metal particles 107, although the present disclosure is not so limited. Nickel may be a conductive metal particles providing an electrical connection between the PCB 101 and the FPCB 102. The nickel (as the conductive metal particles 107) may have a high melting temperature, and when bonding is performed by applying heat and pressure to the ACF 104, nickel may not melt and may maintain a particle state, thereby forming an electrical connection between copper patterns 103.

The content of nickel in ACF 104 is not limited to any particular example. For example, nickel may be included in a content of 5 to 30 weight% based on the total weight of the anisotropic conductive film. When the nickel content is less than 5 weight%, conductivity may degrade, and when the nickel content exceeds 30 weight%, the content of the resin may be insufficient, such that adhesiveness and mechanical strength may degrade.

Nickel in ACF 104 may comprise nickel particles which may be spherical and amorphous, but the present disclosure is not limited to any particular example, and the nickel in ACF 104 may be, for example, spherical. Also, the nickel in ACF 104 may have an average particle diameter of 3 µm to 30 µm.

ACF 104 may also include a solder 108. The solder 108 may be a conductive metal particles, and may melt when bonded using the ACF 104 and may form a soldering alloy layer 109 between copper patterns 103. See lower half of FIG. 1. Accordingly, a contact surface between the copper patterns may be increased such that electrical connection may be stably maintained. Furthermore, since the soldering alloy layer 109 is formed around nickel, electrical contact by nickel "balls" 107 between copper patterns 103 may be firmly maintained by the soldering alloy layer 109, thereby improving reliability of electrical bonding by the anisotropic conductive film.

The solder which may melt when bonded using the ACF 104is not limited to any particular example, and may be a Sn-Bi alloy or a Sn-Au-Cu alloy. More specifically, the solder may be a Sn-Bi alloy. When a Sn-Bi alloy is used as the solder, the Sn-Bi alloy may have a low melting temperature and may be melted in a temperature range where the resin melts, such that electrical contact between copper patterns may be easily formed.

The solder 108 may be included in 20 to 40 parts by weight based on 100 parts by weight of the thermosetting resin 106. When the content of the solder 108 is less than 20 parts by weight, the fusion area of the solder 108 may not be formed sufficiently and electrical contact may be insufficient. When the content exceeds 40 parts by weight, the resin content may be insufficient and adhesiveness and mechanical strength may be lowered.

The solder 108 is not limited to any particular size or shape, and may have, for example, an average particle diameter of 3 um to 30 um. When the particle diameter of the solder 108 is less than 3 µm, the space between the conductive metal particles 107may not be sufficiently filled, such that electrical contact may be insufficient. When the particle diameter of solder 108 exceeds 30 µm, melting may not be sufficiently performed.

As described above, ACF 104 may include either of a nickel component and a solder component or may include both a nickel component and a solder component. When the solder component is included together with the nickel component in the anisotropic conductive film, the contact area between the copper patterns 103 may increase, and electrical connection may be formed.

The conductive bonding portion may further include silica.

Silica may provide structural stability to the anisotropic conductive bonding portion. The silica may prevent separation between the anisotropic conductive film and the copper pattern due to a difference in the degree of curing when the temperature is lowered in the curing process during the bonding process. By allowing ACF 104 to fix the solder 108, structural stability may be provided.

The silica may be included in a content greater than 0 parts by weight to 30 parts by weight or less based on 100 parts by weight of the thermosetting resin 106. When silica is not included in ACF 104, an airgap may be formed during the bonding process, and the structural stability may be lowered. When the silica content exceeds 30 parts by weight, silica may be interposed between nickel particles or the soldering alloy layer and the copper pattern, such that electrical connection may be disturbed.

According to another embodiment, a method of bonding a PCB may include providing a laminate by interposing an anisotropic conductive film (such as ACF 104) including a thermosetting resin (such as thermosetting resin 106) and a conductive metal particles (such as conductive metal particles 107) between a PCB having a copper pattern and a FPCB having a copper pattern; and bonding the PCB to the FPCB by heating and pressurizing the laminate. In one embodiment, at least one or more of the copper pattern of the PCB and the copper pattern of the FPCB has at least one plating layer selected from a group consisting of one or more a Ni plating layer and an Au-Ni plating layer.

A PCB-ACF-FPCB laminate (as shown in the lower half of FIG. 1) may be provided by interposing an anisotropic conductive film including a thermosetting resin, a nickel component, and a Sn-Bi alloy (as a solder) between a PCB having a copper pattern and a FPCB having a copper pattern. In one embodiment, the PCB and the FPCB may be bonded by ultrasonic waves or thermal fusion under heating and pressure on the PCB-ACF-FPCB laminate. Accordingly, bond reliability between the PCB and the FPCB may be improved. In this case, resin of the anisotropic conductive film may be melted by heating and pressurization, and a melted resin may move between the electrodes adjacent to each other of the copper pattern. Furthermore, the Sn-Bi alloy may melt between the copper patterns and may firmly support nickel.

By the point contact of the nickel component and due to the melting of the Sn-Bi alloy, the contact surface between the copper pattern 103 of the PCB and the copper pattern 103 of the FPCB may improve, and an electrical connection may be formed. By at least one of improving the bonding force by the resin, improving the structural stability of bond layer by silica, and improving bonding force by formation of alloy layer between Sn-Bi alloy and copper, electrical bonding reliability may be secured even under severe operating and manufacturing conditions.

In one embodiment of the present disclosure, the heating and pressurizing are not limited to any particular example as long as the resin and the Sn-Bi alloy are melted, which may be performed by ultrasonic waves or a thermal fusion or a combination. In this case, the ultrasonic wave or thermal fusion may be performed under conditions in which the Sn-Bi alloy melts. For example, the heating and pressurizing may be performed by thermal fusion by performing heating at a temperature of 185 to 210°C for 3 to 60 seconds, and pressurizing at a pressure of 1 MPa to 5 MPa for 3 to 60 seconds. Alternatively, the heating and pressurizing may be performed by ultrasonic welding by heating at a temperature of 185 to 210°C for 3 to 60 seconds and pressurizing at a pressure of 1 MPa to 5 MPa for 3 to 60 seconds.

At least one of the copper pattern 103 of the PCB 101 and the copper pattern 103 of the FPCB 102 may have a Ni plating layer. In the case of having a Ni plating layer on the surface of the copper pattern, by allowing alloying with the solder 108 to be performed, results in bonding between the PCB 101 and FPCB 102.

When the Sn-Bi alloy is used as a solder, since nickel has a high affinity with bismuth (Bi) in the solder , a soldering alloy layer may be formed. Accordingly, during bonding, a portion of the solder may be fused with the Ni plating layer coated on the copper pattern surface of the PCB and/or the FPCB, and may form a Ni-Sn alloy layer. More specifically, a Ni₃Sn₄ layer between the copper pattern and the soldering alloy layer may be formed. As a Ni alloy layer is formed on the copper pattern, a conductive bonding portion having a Ni-Sn alloy layer on the surface of the copper pattern after bonding may be formed as depicted in FIG. 3.

The copper pattern of the PCB and the copper pattern of the FPCB may also include an Au-Ni plating layer. When the PCB has an Au-Ni plating layer in addition to a Ni plating layer on the surface of the copper pattern, during bonding, a portion of the solders may be fused with Ni coated on the PCB and the FPCB surfaces and may form a Ni-Sn alloy layer, and the other portion may be fused with the Au-Ni plating layer and may form an Au-Ni-Sn-Bi alloy layer.

An example of forming such an Au-Ni-Sn-Bi alloy layer is illustrated in FIG. 4. FIG. 4 illustrates a bonding portion having an Au-Ni-Sn-Bi alloy layer on the copper pattern surface of the PCB. When the Au-Ni-Sn-Bi alloy layer is additionally included between the copper pattern and the soldering alloy layer, a bonding portion providing an electrical connection between the copper patterns may be formed, and also, the possibility of breaking an electrical connection due to physical shock may be reduced.

In the case of having a conductive bonding portion between the PCB and the FPCB according to another embodiment, the degree of curing may be 70% or more, for example, 70% to 97%. Here, the degree of curing may indicate the degree of curing of resin, and the higher the degree of curing, the higher the structural stability of resin. When the degree of curing is less than 70%, physical strength may be lowered in heat, moisture, and deterioration environments. As the degree of curing is closer to 100%, it may be considered that the curing has been sufficiently performed.

### Detailed Embodiments

Various embodiments of the present disclosure will be described in greater detail below. The disclosed embodiments below are intended to facilitate understanding, and the present disclosure is not limited thereto.

### Embodiment 1

Commercially available RF4 having a thickness of 1.6T was used as the PCB, and commercially available PEN having a thickness of 1 millimeter was used as the FPCB. A copper pattern having a volume of 2oz was formed on the surface of the PCB, and a copper pattern having a volume of 1oz was formed on the surface of the FPCB. In the copper pattern of the PCB and FPCB, a Ni plating layer having a thickness of 5 µm was formed, and an Au-Ni plating layer a thickness of 5 µm was formed.

Epoxy resin, nickel balls (an average particle size 3-30 um) of 20 parts by weight, and Sn-Bi alloy solders (an average particle diameter 3-30 um) of 30 parts by weight, based on 100 parts by weight of the epoxy resin, were included, and were interposed between the PCB and the FPCB using an anisotropic conductive film, thereby forming a laminate.

A conductive bond layer was formed between the PCB and the FPCB by heat fusion by applying heat at a temperature of 185°C for 10 seconds and applying a pressure of 3.7 MPa for 10 seconds to the laminate, thereby bonding the PCB to the FPCB by the conductive bonding.

The degree of curing of the conductive bond layer obtained as above was measured by FTIR analysis, and the results are listed in Table 1.

### Embodiment 2

Bonding was performed in the same manner as in embodiment 1 other than that the bonding was performed by thermal fusion by heating at a temperature of 185°C for 20 seconds and pressurizing at a pressure of 3.7 MPa for 20 seconds.

The degree of curing was measured in the same manner as in embodiment 1, and the results are listed in table 1.

### Embodiment 3

Bonding was performed in the same manner as in embodiment 1, other than that the bonding was performed by thermal fusion by heating at a temperature of 210°C for 10 seconds and pressurizing at a pressure of 3.7 MPa for 10 seconds.

The degree of curing was measured in the same manner as in embodiment 1, and the results are listed in table 1.

### Embodiment 4

Bonding was performed in the same manner as in embodiment 1, other than that the bonding was performed by thermal fusion by heating at a temperature of 210°C for 20 seconds and pressurizing at a pressure of 3.7 MPa for 20 seconds.

The degree of curing was measured in the same manner as in embodiment 1, and the results are listed in table 1.

### Embodiment 5

Bonding was performed in the same manner as in embodiment 1, other than that the bonding was performed by ultrasonic welding by heating at a temperature of 185°C for 15 seconds and pressurizing at a pressure of 2.5 MPa for 15 seconds.

The degree of curing was measured in the same manner as in embodiment 1, and the results are listed in table 1.

### Embodiment 6

Bonding was performed in the same manner as in embodiment 1, other than that the bonding was performed by ultrasonic welding by heating at a temperature of 185°C for 9 seconds and pressurizing at a pressure of 3.7 MPa for 30 seconds.

The degree of curing was measured in the same manner as in embodiment 1, and the results are listed in table 1.

### Embodiment 7

Bonding was performed in the same manner as in embodiment 1, other than that the bonding was performed by ultrasonic welding by heating at a temperature of 185°C for 9.5 seconds and pressurizing at a pressure of 3.7 MPa for 9.5 seconds.

The degree of curing was measured in the same manner as in embodiment 1, and the results are listed in table 1.

### Embodiment 8

Bonding was performed in the same manner as in embodiment 1, other than that the bonding was performed by ultrasonic welding by heating at a temperature of 210°C for 14 seconds and pressurizing at a pressure of 3.7 MPa for 14 seconds.

The degree of curing was measured in the same manner as in embodiment 1, and the results are listed in table 1.

### Comparative example 1

Bonding was performed in the same manner as in embodiment 1, other than that the bonding was performed by ultrasonic welding by heating at a temperature of 185°C for 9 seconds and pressurizing at a pressure of 3.7 MPa for 9 seconds.

The degree of curing was measured in the same manner as in embodiment 1, and the results are listed in table 1.

The results here indicate that resin remained between the copper pattern surface and the soldering alloy layer. Resin remained between the copper pattern surface and the soldering alloy layer because the heat of the bonding was not sufficient or the bonding time was not sufficient, or resin flowed back because pressure was not sufficiently maintained after bonding.

### Embodiment 9

Bonding was performed in the same manner as in embodiment 1, other than that the bonding was performed by ultrasonic welding by heating at a temperature of 195°C for 14 seconds and pressurizing at a pressure of 3.7 MPa for 14 seconds.

The degree of curing was measured in the same manner as in embodiment 1, and the results are listed in table 1.

As a result of the analysis of the intermetallic compound layer, there were no voids and resin between the copper pattern and the solder ball. That is, the intermetallic compound layer was firmly formed. The size of Sn-Bi particle of the solder ball was observed to be relatively small.

### Embodiment 10

Bonding was performed in the same manner as in embodiment 1, other than that Au-Ni plating layer was formed on the copper pattern of the PCB and bonding was performed by ultrasonic welding by heating at a temperature of 190°C for 9.5 seconds and pressurizing for 9.5 seconds at a pressure of 3.7 MPa.

The degree of curing was measured in the same manner as in embodiment 1, and the results are listed in table 1.

**[Table 1]**

| | **Bonding** | | | | | **Degree of curing (%)** |
|---|---|---|---|---|---|---|
| | **Welding method** | **Temperat ure (°C)** | **Heating time (s)** | **Pressure (MPa)** | **Pressurizing time (s)** | |
| **Embodiment 1** | Thermal fusion | 185 | 10 | 3.7 | 10 | 70 |
| **Embodiment 2** | Thermal fusion | 185 | 20 | 3.7 | 20 | 75 |
| **Embodiment 3** | Thermal fusion | 210 | 10 | 3.7 | 10 | 70 |
| **Embodiment 4** | Thermal fusion | 210 | 20 | 3.7 | 20 | 75 |
| **Embodiment 5** | Ultrasonic welding | 185 | 15 | 2.5 | 15 | 80 |
| **Embodiment 6** | Ultrasonic welding | 185 | 9 | 3.7 | 30 | 95 |
| **Embodiment 7** | Ultrasonic welding | 185 | 9.5 | 3.7 | 9.5 | 90 |
| **Embodiment 8** | Ultrasonic welding | 210 | 14 | 3.7 | 14 | 95 |
| **Comparative example 1** | Ultrasonic welding | 185 | 9 | 3.7 | 9 | 80 |
| **Embodiment 9** | Ultrasonic welding | 195 | 14 | 3.7 | 14 | 97 |
| **Embodiment 10** | Ultrasonic welding | 190 | 9.5 | 3.7 | 9.5 | 90 |

The degree of curing in embodiment 9 was 97%. As compared to comparative example 1, the degree of curing was improved by about 17%. It was observed that the degree of curing and efficiency (pattern/total area) were improved when the temperature was increased and the heating time and pressurizing time were increased.

Also, the degree of curing in embodiment 10 was 90%. As compared to comparative example 1, the degree of curing was improved by about 10%. As compared to embodiment 9 without the Au-Ni plating layer, a high degree of curing was obtained even though fusion was performed for a relatively short period of time at a lower temperature.

According to the aforementioned embodiments, by bonding the PCB to the FPCB using an anisotropic conductive film, electrical connection may be formed between the copper pattern surfaces, and bonding strength may be improved such that reliability of electrical bonding may be improved. Accordingly, a stable battery module may be obtained.

While the example embodiments have been illustrated and described above, it will be apparent to those skilled in the art that modifications and variations could be made without departing from the scope of the present disclosure.

## Claims

1. A battery module comprising:
a printed circuit board (PCB) having a copper pattern;
a flexible printed circuit board (FPCB) having a copper pattern; and
a conductive bonding portion for bonding the PCB to the FPCB,
wherein the copper pattern of the PCB and the copper pattern of the FPCB are electrically connected to each other by conductive metal particles, and
wherein at least one of the copper pattern of the PCB and the copper pattern of the FPCB has at least one or more alloy layers selected from a group consisting one or more of Ni-Sn and Au-Ni-Sn-Bi.

2. The battery module of claim 1, wherein the conductive metal particles are formed of at least one or more selected from a group consisting of nickel, a Sn-Bi alloy and a Sn-Au-Cu alloy.

3. The battery module of claim 1 or 2, wherein the conductive bonding portion includes a thermosetting resin.

4. The battery module of claim 3, wherein the conductive bonding portion further includes silica.

5. The battery module of claim 4, wherein the silica is included in a range from more than 0 parts by weight to 30 parts by weight or less based on 100 parts by weight of a thermosetting resin.

6. The battery module of anyone of the preceding claims, wherein the conductive bonding portion has a degree of curing of 70 to 97%.

7. A method of bonding a PCB, the method comprising:
providing a laminate by interposing an anisotropic conductive film including a thermosetting resin and conductive metal particles between a printed circuit board (PCB) having a copper pattern and a flexible printed circuit board (FPCB) having a copper pattern; and
bonding the PCB to the FPCB by heating and pressurizing the laminate,
wherein at least one of the copper pattern of the PCB and the copper pattern of the FPCB has at least one plating layer selected from a group consisting of one or more of a Ni plating layer and an Au-Ni plating layer.

8. The battery module of claim 7, wherein the conductive metal particles are formed of at least one or more selected from a group consisting of nickel, a Sn-Bi alloy and a Sn-Au-Cu alloy.

9. The battery module of claim 7 or 8, wherein the bonding of the PCB to the FPCB is performed by thermal fusion.

10. The battery module of claim 7 or 8, wherein the bonding of the PCB to the FPCB is performed by ultrasonic welding.

11. A battery module comprising:
a printed circuit board (PCB) having a copper pattern;
a flexible printed circuit board (FPCB) having a copper pattern; and
a conductive bonding portion for bonding the PCB to the FPCB,
wherein the conductive bonding portion includes conductive metal particles, a thermosetting resin, and a solder, and
wherein the solder has a higher melting temperature than the thermosetting resin, and the conductive metal particles have a higher melting temperature than the thermosetting resin.
